(19)

Europäisches
Patentamt
European
Patent Office
Office européen
des brevets

(11) **EP 2 562 799 A1**

(12) **EUROPEAN PATENT APPLICATION**
published in accordance with Art. 153(4) EPC

(43) Date of publication:
**27.02.2013 Bulletin 2013/09**

(51) Int Cl.:
*H01L 21/338* (2006.01)   *H01L 29/778* (2006.01)
*H01L 29/812* (2006.01)

(21) Application number: **10850226.1**

(22) Date of filing: **22.04.2010**

(86) International application number:
**PCT/JP2010/057141**

(87) International publication number:
**WO 2011/132285 (27.10.2011 Gazette 2011/43)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(71) Applicant: **Mitsubishi Electric Corporation Tokyo 100-8310 (JP)**

(72) Inventors:
• **OISHI, Toshiyuki**
  **Tokyo 100-8310 (JP)**

• **OTSUKA, Hiroshi**
  **Tokyo 100-8310 (JP)**
• **YAMANAKA, Koji**
  **Tokyo 100-8310 (JP)**
• **INOUE, Akira**
  **Tokyo 100-8310 (JP)**

(74) Representative: **Pfenning, Meinig & Partner GbR Patent- und Rechtsanwälte Theresienhöhe 13 80339 München (DE)**

(54) **SEMICONDUCTOR DEVICE AND METHOD FOR MANUFACTURING SAME**

(57)    In the present invention, provided is a semiconductor device, including: a GaN channel layer which is provided on a substrate and through which electrons run; a barrier layer which is provided on the GaN channel layer and which contains at least one of In, Al, and Ga and contains N; a gate electrode which is provided on the barrier layer; and a source electrode and a drain electrode which are provided on the substrate across the gate electrode, in which, in a portion of the barrier layer between the gate electrode and the drain electrode, a magnitude of polarization of the barrier layer is smaller on the gate electrode side than on the drain electrode side. Thus, PAE can be improved by reducing Rd and Cgd simultaneously.

FIG. 1

**Description**

Technical Field

The present invention relates to a semiconductor device and a method of manufacturing the same, and more particularly, to a structure for enhancing the efficiency of a high-electron mobility transistor device that uses a nitride semiconductor, typically GaN, or other similar semiconductor devices, and a method of manufacturing the structure.

Background Art

In HEMTs that use a nitride semiconductor, typically GaN (hereinafter referred to as GaN HEMTs), or other similar conventional semiconductor devices, the thickness of an AlGaN barrier layer is constant for a stretch from a gate electrode to a drain electrode. The following description takes as an example Non-Patent Literature 1, "Current Status of X-Band and Ku-Band High Power GaN HEMTs" published in 2009 in IEICE Transactions, vol. J92-C, on page 762. As shown in this document, a semiconductor GaN channel and an AlGaN barrier are on an SiC substrate, and a source electrode, a gate electrode, and a drain electrode are formed thereon. The AlGaN barrier has a thickness that is constant for a stretch from the gate electrode to the drain electrode.

Citation List

Non Patent Literature

[NPL 1] Kazutaka Takagi, "Current Status of X-Band and Ku-Band High Power GaN HEMTs", IEICE Transactions, The Institute of Electronics,Information and Communication Engineers, Vol. J92-C, No. 12, pp. 762-769

Summary of Invention

Technical Problem

GaN HEMTs are used as microwave amplifiers. One of important indicators in an amplifier is power-added efficiency (PAE). This is an indicator for how efficiently a DC input and an RF input are converted into an RF output. Electric power that is not converted into the RF output is wasted by turning into heat. A low PAE therefore means that a larger power source is required to obtain the same RF output, which gives rise to a problem of increased system size. In a system for which an upper limit is put on the power source size, in particular, improving PAE is very important.
PAE given as ηadd is expressed by the following Expression (1) with the use of a gain G and a drain efficiency ηd:

[Math. 1]

$$\eta_{add} = \left(1 - \frac{1}{G}\right)\eta_d \qquad (1)$$

Expression (1) shows that increasing the gain G and the drain efficiency ηd is a factor for PAE improvement.
The gain G is expressed by the following Expression (2) :

[Math. 2]

$$G = A\frac{g_m}{C_{gd}} \qquad (2)$$

where A represents a proportionality constant, gm represents a mutual conductance, and Cgd represents a gate-drain capacitance. Expression (2) shows that the gain G can be increased by increasing gm and reducing Cgd. The mutual conductance gm is increased by lowering the source resistance (Rs).

The drain efficiency $\eta$d, on the other hand, is an indicator indicating whether or not electric power can be transmitted to a load, and therefore the drain efficiency $\eta$d rises when power consumption at the load increases. A power consumption $P_{RL}$ at the load is expressed by the following Expression (3):

[Math. 3]

$$P_{RL} = \frac{|I_{ds}|^2}{4[R_d\{G_{ds}^2 + \omega^2(C_{ds} + C_{gd})^2\} + G_{ds}]} \tag{3}$$

where Rd represents a drain resistance, Gds represents an inverse number of the source-drain resistance, $\omega$ represents an angular frequency, Ids represents a drain current, and Cds represents a source-drain capacitance. As shown by Expression (3), reducing Rd, Cds, Cgd, or others increases the power consumption $P_{RL}$ at the load, and is therefore effective in improving $\eta$d. It is understood from the above discussion that PAE can be improved by reducing Rd and Cgd simultaneously.

However, Cgd reduction and Rd reduction have a trade-off relation in a structure where the thickness of the AlGaN film is constant as in the conventional example of Non-Patent Literature 1. Specifically, reducing Rd by thickening the AlGaN barrier increases the volume of two-dimensional electron gas in the channel. An increase in electron concentration due to the two-dimensional electron gas increases Cgd. Reducing Rd thus increases Cgd and, conversely, reducing Cgd increases Rd, thereby making it difficult to reduce Rd and Cgd simultaneously. Conventional semiconductor devices have attempted to optimize their structures under this Rd-Cgd trade-off condition, and accordingly have had a limited success in improving PAE.

The present invention has been made to solve this problem, and an object of the present invention is to obtain a semiconductor device that is improved in PAE by reducing Rd and Cgd simultaneously, and a method of manufacturing the semiconductor device.

Solution to Problem

According to the present invention, there is provided a semiconductor device, including: a GaN channel layer which is provided on a substrate and through which electrons run; a barrier layer which is provided on the GaN channel layer and which contains at least one of In, Al, and Ga and contains N; a gate electrode which is provided on the barrier layer; and a source electrode and a drain electrode which are provided on the substrate across the gate electrode, in which, in the barrier layer between the gate electrode and the drain electrode, a magnitude of polarization is smaller on the gate electrode side than on the drain electrode side.

Advantageous Effects of Invention

According to the present invention, the semiconductor device includes: the GaN channel layer which is provided on the substrate and through which electrons run; the barrier layer which is provided on the GaN channel layer and which contains at least one of In, Al, and Ga and contains N; the gate electrode which is provided on the barrier layer; and the source electrode and the drain electrode which are provided on the substrate across the gate electrode, and, in the barrier layer between the gate electrode and the drain electrode, the magnitude of polarization is smaller on the gate electrode side than on the drain electrode side. Thus, PAE can be improved by reducing Rd and Cgd simultaneously.

Brief Description of Drawings

[FIG. 1] A sectional view illustrating the structure of a semiconductor device according to a first embodiment of the present invention.
[FIG. 2] A graph showing the relation of the AlGaN barrier thickness on the gate side with the gain, the drain efficiency, and the PAE in the semiconductor device according to the first embodiment of the present invention.
[FIG. 3] A graph showing the relation of the AlGaN barrier thickness on the gate side with the gain, the drain efficiency, and the PAE in the semiconductor device according to the first embodiment of the present invention.

[FIG. 4] A sectional view illustrating the structure of a semiconductor device according to a second embodiment of the present invention.

[FIG. 5] A graph showing the relation of the AlGaN barrier thickness with the gain, the drain efficiency, and the PAE in the semiconductor device according to the second embodiment of the present invention.

[FIG. 6] A graph showing the relation of the AlGaN barrier thickness with the gain, the drain efficiency, and the PAE in the semiconductor device according to the second embodiment of the present invention.

[FIG. 7] A sectional view illustrating the structure of a semiconductor device according to a third embodiment of the present invention.

[FIG. 8] A graph showing the relation of the AlGaN barrier thickness with the gain, the drain efficiency, and the PAE in the semiconductor device according to the third embodiment of the present invention.

[FIG. 9] A graph showing the relation of the AlGaN barrier thickness with the gain, the drain efficiency, and the PAE in the semiconductor device according to the third embodiment of the present invention.

[FIG. 10] A graph showing the relation of the AlGaN barrier thickness with the gain, the drain efficiency, and the PAE in the semiconductor device according to the third embodiment of the present invention.

[FIG. 11] A graph showing the relation of a length for which AlGaN3 is left on the gate side with the gain, the drain efficiency, and the PAE in the semiconductor device according to the third embodiment of the present invention.

[FIG. 12] A view illustrating a method of manufacturing the semiconductor device according to the first embodiment of the present invention.

[FIG. 13] A view illustrating the method of manufacturing the semiconductor device according to the first embodiment of the present invention.

[FIG. 14] A view illustrating the method of manufacturing the semiconductor device according to the first embodiment of the present invention.

[FIG. 15] A view illustrating the method of manufacturing the semiconductor device according to the first embodiment of the present invention.

[FIG. 16] A view illustrating a method of manufacturing the semiconductor device according to the second embodiment of the present invention.

[FIG. 17] A view illustrating the method of manufacturing the semiconductor device according to the second embodiment of the present invention.

[FIG. 18] A view illustrating the method of manufacturing the semiconductor device according to the second embodiment of the present invention.

[FIG. 19] A view illustrating the method of manufacturing the semiconductor device according to the second embodiment of the present invention.

[FIG. 20] A view illustrating a method of manufacturing the semiconductor device according to the third embodiment of the present invention.

[FIG. 21] A view illustrating the method of manufacturing the semiconductor device according to the third embodiment of the present invention.

[FIG. 22] A view illustrating the method of manufacturing the semiconductor device according to the third embodiment of the present invention.

[FIG. 23] A view illustrating the method of manufacturing the semiconductor device according to the third embodiment of the present invention.

[FIG. 24] A view illustrating another method of manufacturing the semiconductor device according to the third embodiment of the present invention.

[FIG. 25] A view illustrating the other method of manufacturing the semiconductor device according to the third embodiment of the present invention.

[FIG. 26] A view illustrating the other method of manufacturing the semiconductor device according to the third embodiment of the present invention.

[FIG. 27] A view illustrating the other method of manufacturing the semiconductor device according to the third embodiment of the present invention.

Description of Embodiments

A semiconductor device according to the present invention includes a GaN channel layer through which electrons run, and a barrier layer which is provided in order to form two-dimensional electron gas for the GaN channel layer and which contains at least one of In, Al, and Ga and contains N. PAE improvement is attempted in this structure by reducing a drain resistance Rd and a gate-drain capacitance Cgd simultaneously. Specifically, the thickness (and/or composition) of the barrier layer is controlled between a gate electrode and a drain electrode so that the polarization of the barrier layer on the gate electrode side is smaller in magnitude than on the drain electrode side. The constraint of Rd-Cgd trade-off in prior art is thus lifted and a marked improvement in PAE can be expected. Reducing Cgd is particularly important because a reduction in Cgd improves the gain and the drain efficiency both. Further, a source resistance Rs is reduced by making the barrier layer structure on the source electrode side the same as the barrier layer structure on the drain electrode side. Consequently, according to the present invention, Rd, Rs, and Cgd can be reduced simultaneously and the PAE is improved even more.

First Embodiment

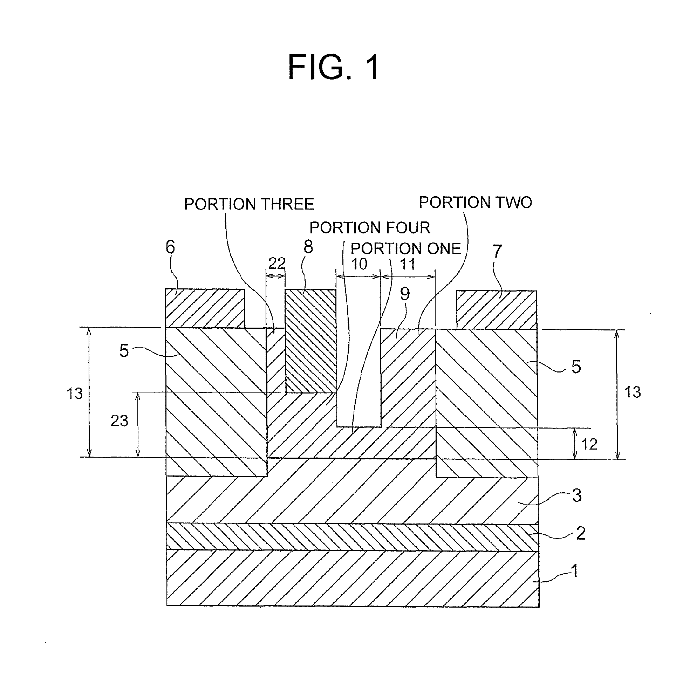

FIG. 1 is a sectional view illustrating the structure of a semiconductor device according to a first embodiment of the present invention. FIG. 1 takes a GaN HEMT as an example of the semiconductor device. In FIG. 1, reference symbol 1 denotes a substrate; 2, a buffer which is provided on the substrate 1; 3, a GaN channel which is provided on the buffer 2 and through which electrons run; 5, n-type impurities which are provided in a high concentration on the GaN channel 3 (hereinafter referred to as n+ region 5); 6, a source electrode which is provided on the n+ region 5; 7, a drain electrode which is provided on the n+ region 5; and 8, a gate electrode which is provided on an AlGaN barrier 9 described later.

The AlGaN barrier (barrier layer) 9 is provided on the GaN channel 3 in order to form two-dimensional electron gas in the GaN channel 3. The AlGaN barrier 9 has a plurality of thicknesses to constitute a structure with concavities and convexities. In FIG. 1, reference symbol 10 denotes Distance One; 11, Distance Two; 12, the thickness of a portion of the AlGaN barrier 9 for Distance One (reference symbol: 10) (hereinafter referred to Portion One); 13, the thickness of a portion of the AlGaN barrier 9 for Distance Two (reference symbol: 11) (hereinafter referred to Portion Two); 22, Distance Three which is the width of a portion of the AlGaN barrier 9 between the gate electrode 8 and the source electrode 6 (hereinafter referred to as Portion Three); and 23, the thickness of a portion of the AlGaN barrier 9 below the gate electrode 8 (hereinafter referred to as Portion Four). Portion One is a portion of the AlGaN barrier 9 between the gate electrode 8 and the drain electrode 7 that is on the side of the gate electrode 8 (a region on the side of the gate electrode 8). Portion Two is a portion of the AlGaN barrier 9 between the gate electrode 8 and the drain electrode 7 that is not Portion One (a drain electrode-side region).

While FIG. 1 illustrates the n+ region 5, the n+ region 5 may not always be formed and the GaN HEMT operates normally in that case, too. The semiconductor device is actually provided with, in addition to the components described above, an element isolation region, wiring, a protective film, and the like which are irrelevant to the operation of the present invention and are therefore omitted from FIG. 1.

The GaN HEMT of the present invention can be used as a single amplifier and also as a transistor that constitutes an MMIC. The substrate 1 is a sapphire substrate, an SiC substrate, an Si substrate, a GaN substrate, or the like. In particular, a semi-insulating SiC substrate which is high in heat conductivity is commonly used as the substrate 1. The buffer 2 is a layer interposed between the substrate 1 and the GaN channel 3. Various structures such as AlN, AlGaN, GaN/InGaN, and AlN/AlGaN are used as the buffer 2 for the purpose of improving the crystallinity of the GaN channel 3 and trapping electrons in the GaN channel 3. The n+ region 5 is formed below the source electrode 6 and the drain electrode 7 for the purpose of lowering the contact resistance of the source electrode 6 and the drain electrode 7. In this embodiment, the effect is obtained without the n+ region 5 if an ohmic contact is formed with the source electrode 6 and the drain electrode 7, but including the n+ region 5 is more desirable.

The operation of the semiconductor device according to the first embodiment is described next. As described above, reducing Rs, Rd, and Cgd is important for PAE improvement. Rs is defined as the resistance from the source electrode 6 to the gate electrode 8, and Rd is defined as the resistance from the gate electrode 8 to the drain electrode 7. Cgd is the capacitance between the gate electrode 8 and the drain electrode 7. When the semiconductor device (amplifier) is in operation, a bias is applied between the gate electrode 8 and the drain electrode 7 in a backward direction. A voltage between the gate electrode 8 and the drain electrode 7 is therefore applied mainly on the side of the gate electrode 8. This means that Cgd is formed on the side of the gate electrode 8 between the gate electrode 8 and the drain electrode 7. Cgd is reduced by reducing electron concentration. It is concluded from the above descriptions that Cgd should be reduced by setting a low electron concentration to one region between the gate electrode 8 and the drain electrode 7 that is on the side of the gate electrode 8, and Rd should be also reduced by setting a high electron concentration to the other region between the gate electrode 8 and the drain electrode 7 that is not the gate electrode-side region. Distance One (reference symbol: 10) necessary to reduce Cgd is short and is considered to have substantially no influence on Rd as described later.

The electron concentration of the channel in a GaN HEMT depends on the level of influence of polarization (specifically, on the magnitude of polarization and the thickness of the AlGaN barrier 9). Due to the surface influence, the electron concentration is low when the AlGaN barrier 9 is thin whereas the electron concentration is high when the AlGaN barrier 9 is thick. Accordingly, Cgd is reduced by setting the thickness 12 thin in Portion One of the AlGaN barrier 9 corresponding to Distance One (reference symbol: 10) on the side of the gate electrode 8 as illustrated in FIG. 1. Rd is reduced by setting the thickness 13 thick in Portion Two of the AlGaN barrier 9 corresponding to Distance Two (reference symbol: 11) on the side of the drain electrode 7. As to Rs, the thickness of Portion Three of the AlGaN barrier 9 corresponding to Distance Three (reference symbol: 22) between the source electrode 6 and the gate electrode 8 should be thick. In Fig. 1, the thickness of Portion Three is thus set to the same thickness as the thickness 13 of Portion Two. The pinch-off voltage is determined from the thickness 23 of a portion of the AlGaN barrier 9 right below the gate electrode 8 (hereinafter referred to as Portion Four). Including the thickness 23 which is the thickness of the AlGaN barrier 9 in Portion Four right below the gate electrode 8, the AlGaN barrier 9 in the first embodiment has three different thicknesses 12, 13, and 23 for a stretch from the source electrode 6 to the drain electrode 7.

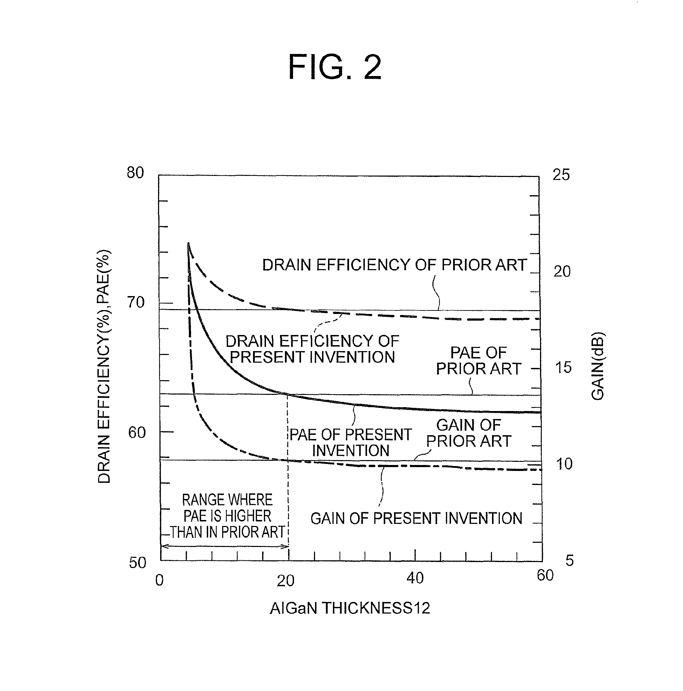

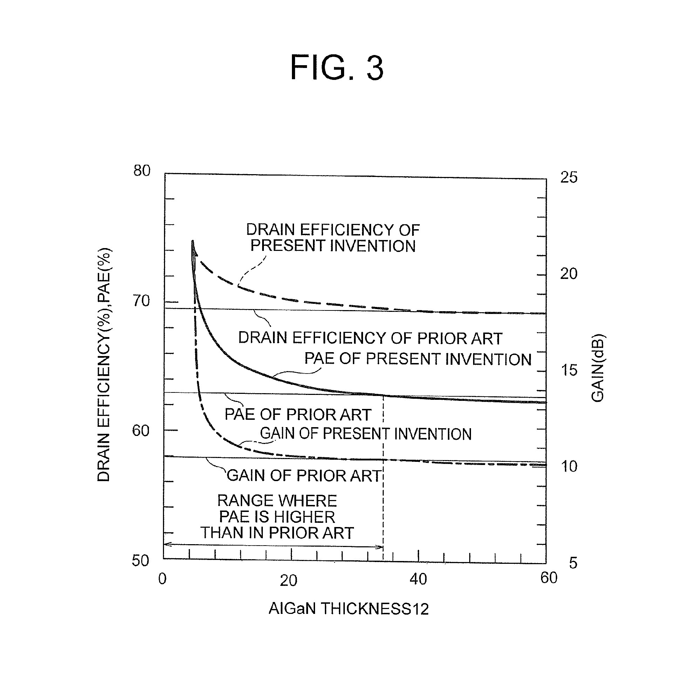

Next, the result of calculating the gain, drain efficiency and PAE of the structure of FIG. 1 is described. FIG. 2 shows a calculation result obtained for a structure in which the Al composition of the AlGaN barrier 9 is 0.2, the thickness 13 of Portion Two of the AlGaN barrier 9 corresponding to Distance Two (reference symbol: 11) is 20 nm, and the thickness 23 of Portion Four right below the gate electrode 8 is 10 nm when the thickness 12 of Portion One of the AlGaN barrier 9 corresponding to Distance One (reference symbol: 10) is varied. FIG. 3 shows a calculation result obtained for a structure in which the Al composition of the AlGaN barrier 9 is 0.2, the thickness 13 of Portion Two of the AlGaN barrier 9 corresponding to Distance Two (reference symbol: 11) is 40 nm, and the thickness 23 of Portion Four right below the gate electrode 8 is 10 nm. In FIGS. 2 and 3, a bold line represents the PAE of this embodiment, a broken line represents a drain efficiency $\eta d$ of this embodiment, and a dot-dash line represents a gain G of this embodiment.

It is understood from the calculation results of FIGS. 2 and 3 that setting the thickness 12 of Portion One of the AlGaN barrier 9 thin improves all of the gain G, the drain efficiency $\eta d$, and the PAE. For comparison, FIGS. 2 and 3 show, with the use of thin solid lines, calculation results obtained for a conventional structure in which the Al composition is 0.2 and the AlGaN barrier has a constant thickness of 10 nm. In Fig. 2, a PAE higher than that in the prior art example is obtained when the thickness 12 of Portion One of the AlGaN barrier 9 is 20 nm or less. In FIG. 3, a PAE higher than that in the prior art example is obtained when the thickness 12 of Portion One of the AlGaN barrier 9 is 36 nm or less in FIG. 3. From this result, it is concluded that, in this embodiment, a PAE higher than in prior art is obtained by setting the thickness 12 of Portion One of the AlGaN barrier 9 thinner than the thickness 13 of Portion Two and Portion Four of the AlGaN barrier 9. The PAE improves to a remarkable degree particularly when the thickness 12 of Portion One of the AlGaN barrier 9 is 20 nm or less, and it is therefore desirable to set the thickness 12 of Portion One of the AlGaN barrier 9 to 20 nm or less. In the calculations of FIGS. 2 and 3, Distance Three (reference symbol: 22) between the gate electrode 8 and the n+ region 5 is set to 3 $\mu$m, and Distance One (reference symbol: 10) on the side of the gate electrode 8 is set to 1 $\mu$m.

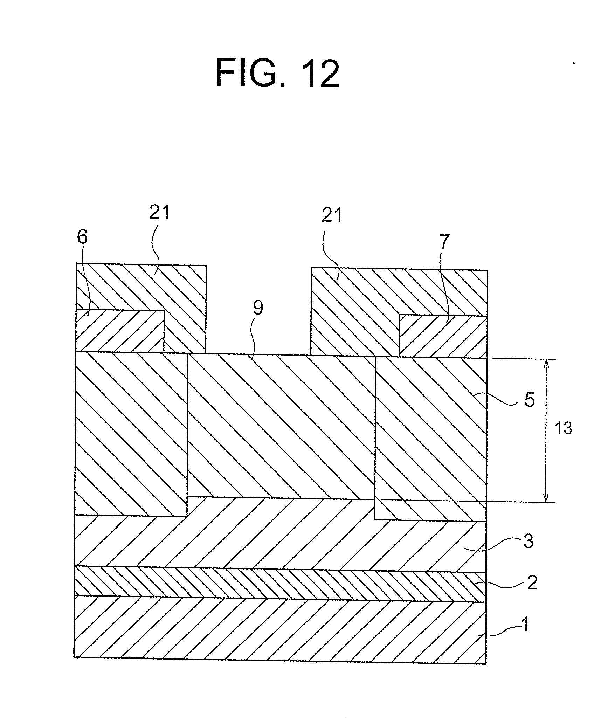

Next, a method of manufacturing the semiconductor device according to the first embodiment is described with reference to FIGS. 12 to 15. In FIG. 12, a reference symbol 21 is used to denote a resist.

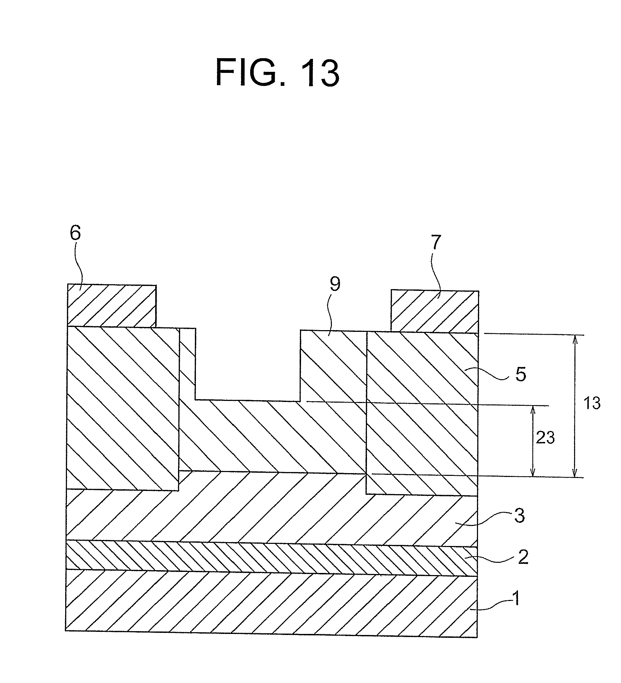

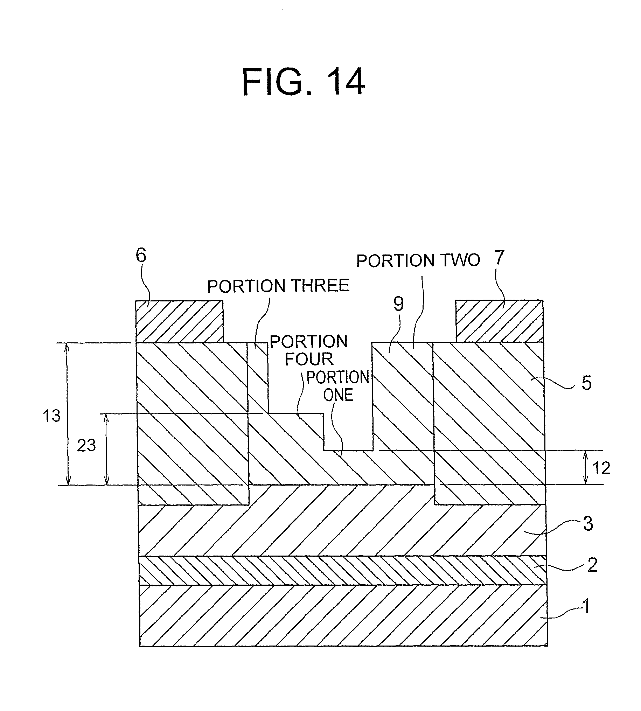

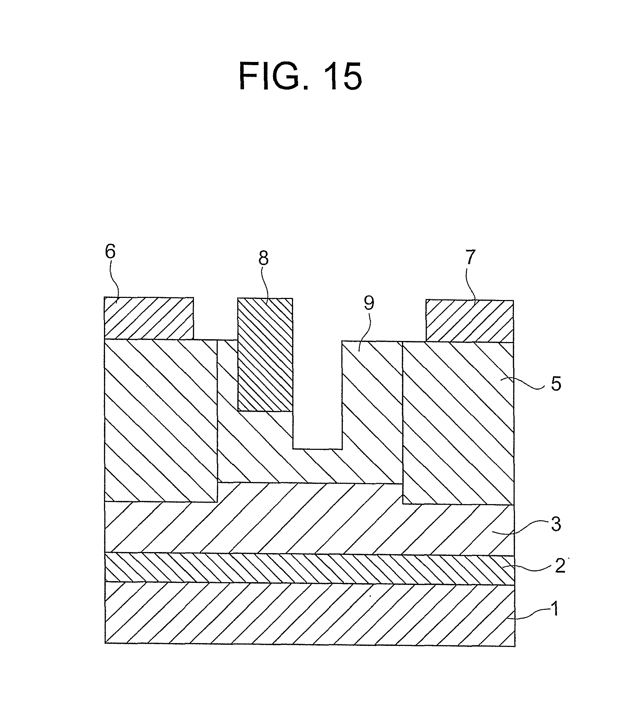

First, the buffer 2, the GaN channel 3, and the AlGaN barrier 9 are sequentially grown on the substrate 1 through crystal growth. MOCVD and MBE can be used for the crystal growth. The thickness of the AlGaN barrier 9 at this step is uniform at the thickness 13. Next, the n+ region 5, the source electrode 6, and the drain electrode 7 are formed by using photolithography and lift-off. Up to this stage, the semiconductor device can be manufactured by the same steps as in prior art. Next, as illustrated in FIG. 12, portions of the AlGaN barrier 9 that are not to be removed by etching is covered with the resist 21. An exposed portion of the AlGaN barrier 9 which is not covered with the resist 21 is then removed by plasma etching or chemical etching. The AlGaN barrier 9 can be etched by exposing the AlGaN barrier 9 to, for example, a mixed gas of chlorine gas and Ar gas in the form of plasma. An SiO or SiN film may be used as a mask, instead of the resist 21. After the etching, the resist 21 is removed and the exposed portion of the AlGaN barrier 9 which has not been covered with the resist 21 is thinned and now has the thickness 23 as illustrated in FIG. 13. Another resist pattern is formed to perform etching again. This forms a portion having the thickness 12, which is even thinner than the thickness 23, in a part of the portion that has had the thickness 23, thereby forming a structure that has two level differences (Portion One to Portion Four) as illustrated in FIG. 14. Next, the gate electrode 8 is formed on Portion Four of the AlGaN barrier 9 which has the thickness 23 as illustrated in FIG. 15. The gate electrode 8 can be formed by photolithography and lift-off. The structure of FIG. 1 is manufactured through the steps described above.

As has been described, in this embodiment, Portion One of the barrier layer between the gate electrode 8 and the drain electrode 7 which is on the side of the gate electrode 8 is given a thickness thinner than that of Portion Two of the barrier layer which is on the side of the drain electrode 7. This makes the magnitude of polarization of the barrier layer between the gate electrode 8 and the drain electrode 7 on the side of the gate electrode 8 smaller than on the side of the drain electrode 7. The thickness of the barrier layer between the gate electrode 8 and the drain electrode 7 in this embodiment is controlled in this manner to set a low electron concentration on the side of the gate electrode 8 for Cgd reduction, and to set a high electron concentration on the side of the drain electrode 7 for Rd reduction. The problem of the constraint of Cgd-Rd trade-off in prior art is thus solved and Cgd and Rd can be reduced simultaneously. Further, Rs is reduced in this embodiment by making Portion Three of the barrier layer thick between the source electrode 6 and the gate electrode 8. All of the three parameters Rd, Rs, and Cgd are thus reduced simultaneously, and a semiconductor device that is markedly improved in PAE and low in power consumption is realized. The structure of this embodiment is very effective for a high frequency such as millimeter waves because the characteristics of the gain and the drain efficiency are such that the gain and the drain efficiency drop when the frequency rises.

The above description takes the AlGaN barrier 9 as an example of the barrier layer, but the barrier layer is not limited thereto. As the barrier layer, a GaN layer having an Al composition of 0, an AlN layer having an Al composition of 1, or any other barrier layers that are composed of $Al_xGa_{1-x}N$ ($0<x\leq1$) can be used.

Second Embodiment

The first embodiment has described an example in which the barrier layer is formed from a single Al composition (the AlGaN barrier 9). A second embodiment describes an example in which the barrier layer is formed from a plurality of Al compositions different from one another. The second embodiment which uses the plurality of Al compositions has an advantage in that selective etching can be performed, which improves the controllability of a process and stabilizes electric characteristics.

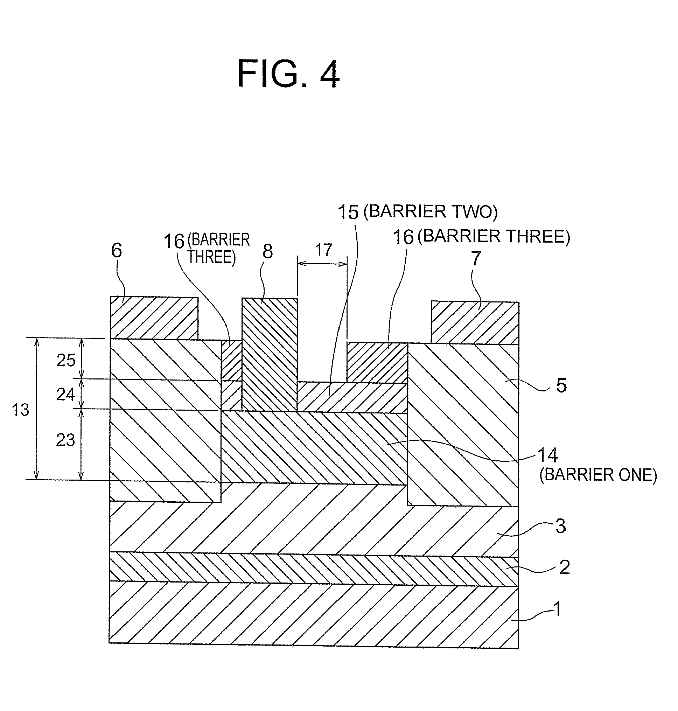

FIG. 4 is a sectional view illustrating the structure of a semiconductor device according to the second embodiment. In FIG. 4, reference numeral 14 denotes an AlGaN barrier (hereinafter referred to as Barrier One); 15, an AlGaN barrier that has a lower Al composition than that of Barrier One (reference symbol: 14) (hereinafter referred to as Barrier Two); 16, an AlGaN barrier that has an Al composition equal to or higher than that of Barrier Two (reference symbol: 15) (hereinafter referred to as Barrier Three); 17, Distance Four of a portion on the side of the gate electrode 8 (hereinafter referred to as Portion Five) in which Barrier Three (reference symbol: 16) is removed; 24, the thickness of Barrier Two (reference symbol: 15); and 25, the thickness of Barrier Three (reference symbol: 16). The length of Distance Four (reference symbol: 17) is substantially the same as that of Distance One (reference symbol: 10) of FIG. 1. The sum of the thicknesses 23, 24, and 25 is substantially the same as the thickness 13. The other components are the same as in the first embodiment, and are denoted by the same reference symbols in order to omit their descriptions here.

As described in the first embodiment, the electron concentration of the channel in a GaN HEMT depends on the polarization of the barrier layer. The magnitude of polarization is greater when the Al composition is higher. The magnitude of polarization can therefore be increased by stacking an AlGaN barrier with a high Al composition on an AlGaN barrier. Conversely, the magnitude of polarization can be reduced by stacking an AlGaN barrier with a low Al composition on an AlGaN barrier. Accordingly, Barrier One (reference symbol: 14) having the thickness 23 is provided on the GaN channel 3 between the gate electrode 8 and the drain electrode 7 as illustrated in FIG. 4. Barrier Two (reference symbol: 15) having the thickness 24 is provided on Barrier One (reference symbol: 14). Barrier Two (reference symbol: 15) is an AlGaN barrier that has a low Al composition. Further, Barrier Three (reference symbol: 16) having the thickness 25 is provided on Barrier Two (reference symbol: 15) on the side of the drain electrode 7. Barrier Three (reference symbol: 16) is an AlGaN barrier having a high Al composition. Thus, only Barrier Two which has a low Al composition is provided on the side of the gate electrode 8 whereas Barrier Three which has a high Al composition is provided on top of Barrier Two on the side of the drain electrode 7. This makes the magnitude of polarization smaller on the side of the gate electrode 8 and larger on the side of the drain electrode 7.

As has been described in the first embodiment, the level of influence of polarization can be increased also by thinning the barrier. Barrier Three therefore does not need to be removed completely from the side of the gate electrode 8 and it is sufficient if Barrier Three is partially removed. However, the maximum effect is obtained when Barrier Three is removed completely from the side of the gate electrode 8.

In the second embodiment, too, the barrier layer structure between the gate electrode 8 and the source electrode 6 is the same as the barrier layer structure on the side of the drain electrode 7 for the purpose of reducing Rs. Barrier Two and Barrier Three are stacked in order on top of Barrier One in the barrier layer between the gate electrode 8 and the source electrode 6. This makes the barrier layer thick and reduces Rs.

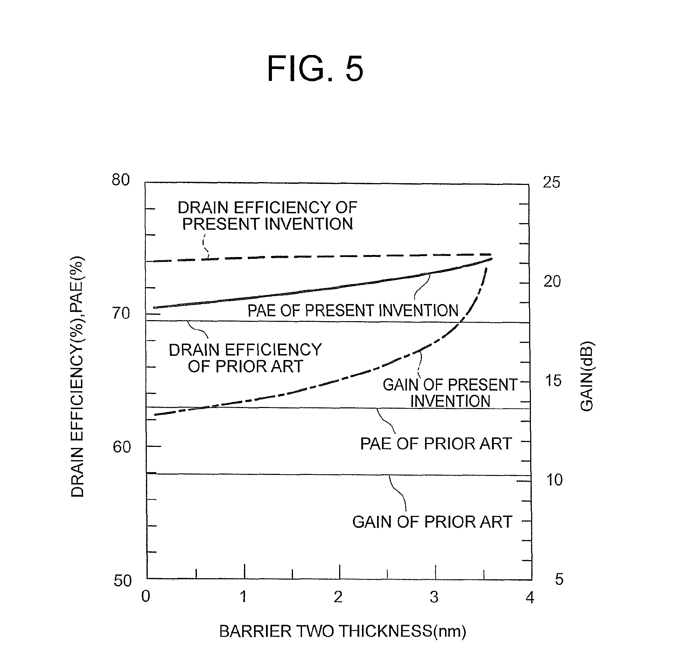

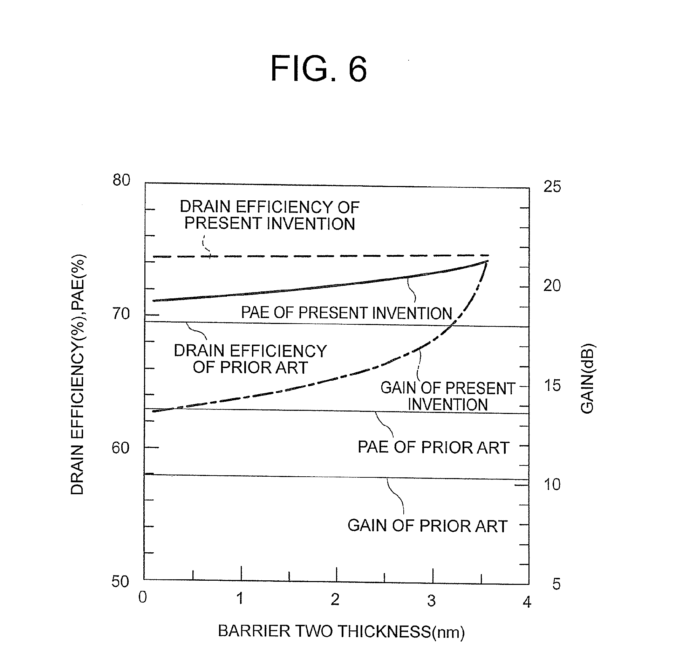

FIGS. 5 and 6 show calculation results obtained for a structure in which Barrier One (reference symbol: 14) has the Al composition of 0.2 and the thickness 23 of 10 nm, similar to the AlGaN barrier 9 of the first embodiment, when the thickness 24 of Barrier Two (reference symbol: 15) is varied. Barrier Two (reference symbol: 15) has an Al composition of 0 (GaN). In Barrier Three of FIG. 5, the Al composition is 1 (AlN) and the thickness 25 is 2 nm. In Barrier Three of FIG. 6, the Al composition is 0.3 and the thickness 25 is 20 nm. It is understood from FIGS. 5 and 6 that the PAE improves when the thickness 24 of Barrier Two (reference symbol: 15) is thicker. Further, a PAE higher than that of a conventional device which is represented by a thin solid line in Figs. 5 and 6 is obtained at any thickness, thereby proving the effectiveness of this structure.

Barrier Two (reference symbol: 15) and Barrier Three (reference symbol: 16) are used only to control the magnitude of polarization, and are distant from the GaN channel 3 through which electrons run. Barrier Two (reference symbol: 15) and Barrier Three (reference symbol: 16) therefore do not need to be crystal layers, and may be polycrystalline or amorphous layers. Since Barrier Two (reference symbol: 15) and Barrier Three (reference symbol: 16) are required only to control polarization magnitude, Barrier Two (reference symbol: 15) and Barrier Three (reference symbol: 16) are also not limited to AlGaN, and can be InGaN, AlInGaN, or any other materials that are a combination of In, Ga, Al, and N.

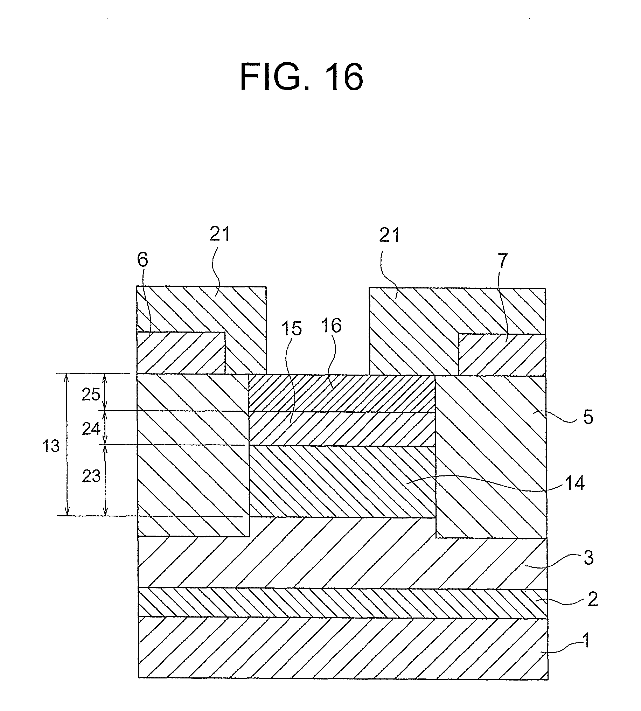

Next, a method of manufacturing the semiconductor device according to the second embodiment is described with reference to FIGS. 16 to 19.

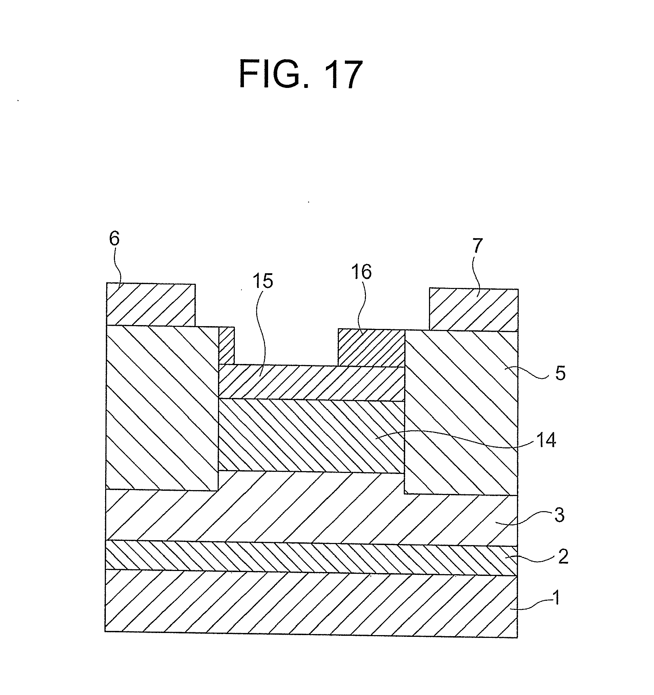

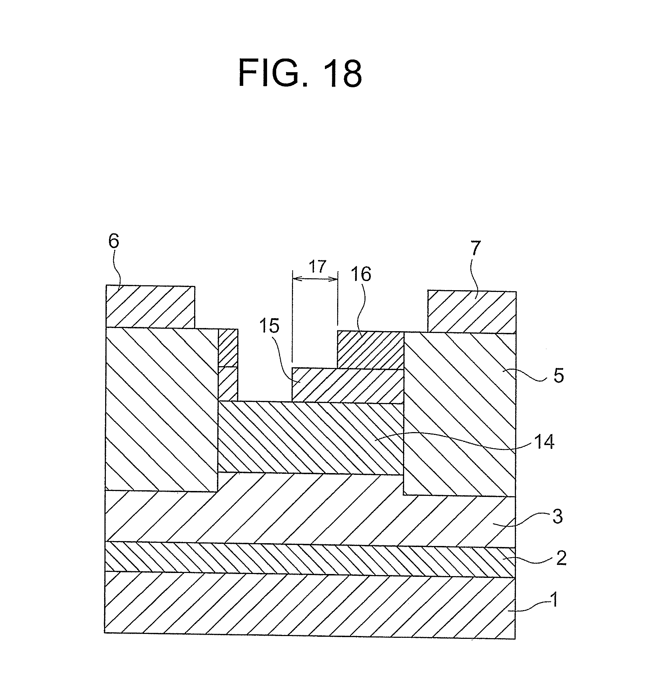

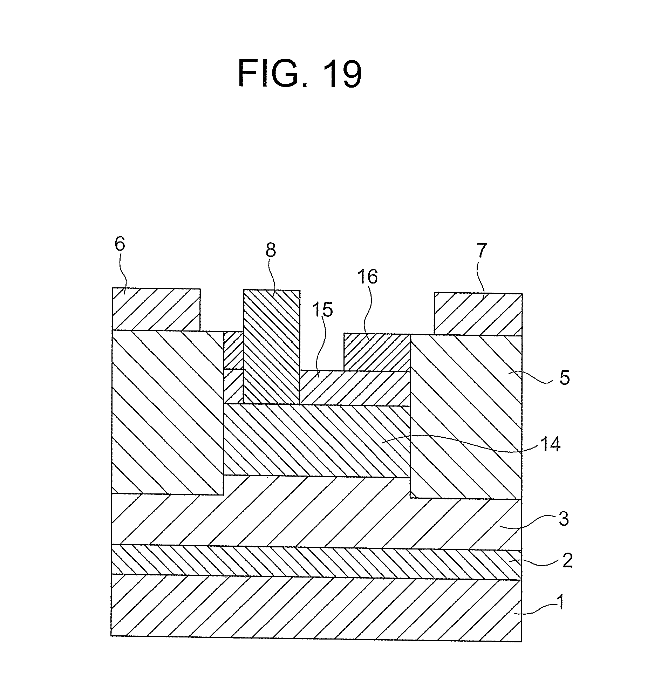

First, the buffer 2, the GaN channel 3, Barrier One (reference symbol: 14), Barrier Two (reference symbol: 15), and Barrier Three (reference symbol: 16) are grown sequentially on the substrate 1 through crystal growth by a crystal growth method such as MOCVD or MBE. Barrier Two (reference symbol: 15) and Barrier Three (reference symbol: 16) do not need to be crystal layers and may be polycrystalline or amorphous layers. Therefore, Barrier Two (reference symbol: 15) and Barrier Three (reference symbol: 16) may be formed by other methods such as sputtering or evaporation. Barrier One to Barrier Three (reference symbols: 14 to 16) are formed so that the sum of the thickness 23 of Barrier One (reference symbol: 14), the thickness 24 of Barrier Two (reference symbol: 15), and the thickness 25 of Barrier Three (reference symbol: 16) is equal to the thickness 13. Next, as illustrated in FIG. 16, the resist 21 is formed so that an exposed opening is formed in a portion where Barrier Three (reference symbol: 16) is to be removed. After Barrier Three (reference symbol: 16) is thus selectively removed by plasma etching or chemical etching, the resist 21 is removed. Thus, a structure illustrated in FIG. 17 can be obtained. Next, another resist is formed so that an exposed opening is formed in a portion where Barrier Two (reference symbol: 15) is to be removed. This resist is removed after Barrier Two (reference symbol: 15) is selectively removed by plasma etching or chemical etching. Thus, a structure as illustrated in FIG. 18, in which Barrier Two (reference symbol: 15) is selectively removed, is obtained. Here, when Barrier Two (reference symbol: 15) is selectively removed, it is performed so that the difference between the distance of Barrier Two (reference symbol: 15) and the distance of Barrier Three (reference symbol: 16) equals Distance Four (reference symbol: 17). Next, the gate electrode 8 is formed in the portion fromwhich Barrier Two (reference symbol: 15) has been removed as illustrated in FIG. 19. In the etching of FIGS. 17 and 18, the AlGaN barrier that contains GaN and that has a low Al composition (Barrier Two) can be removed selectively by adding gas that contains oxygen or fluorine to chlorine gas. In the etching of FIG. 16, AlN or the AlGaN barrier that has a high Al composition (Barrier Three) can be removed selectively by a liquid that contains KOH. The etching in this case is performed effectively by irradiating the barrier with light. The etching of a polycrystalline or amorphous barrier layer tends to be easier than the etching of a crystal barrier layer.

As has been described, the thickness 24 of a region of the barrier layer between the gate electrode 8 and the drain electrode 7 that is on the side of the gate electrode 8 is made thinner than the thickness (24+25) of a region of the barrier layer on the side of the drain electrode 7 in the second embodiment by selectively stacking a plurality of barrier layers (Barrier One, Barrier Two, and Barrier Three) different from one another in Al composition. This makes the magnitude of polarization of the barrier layer on the side of the gate electrode 8 smaller than on the side of the drain electrode 7. In this embodiment, the thickness of the barrier layer between the gate electrode 8 and the drain electrode 7 is thus controlled to set a low electron concentration on the side of the gate electrode 8 and to set a high electron concentration on the side of the drain electrode 7. The problem of the constraint of Cgd-Rd trade-off in prior art is thus solved, and Cgd and Rd can be reduced simultaneously. In addition, by combining varying the barrier layer thickness with providing low-Al composition Barrier Two on the side of the gate electrode 8 and providing a high-Al composition Barrier Three on the side of the drain electrode 7, the difference in the magnitude of barrier layer polarization is made clearer between the side of the gate electrode 8 and the side of the drain electrode 7. Further, Rs is reduced in this embodiment by making the thickness (24+25) of a portion of the barrier layer thick between the source electrode 6 and the gate electrode 8. All of the three parameters Rd, Rs, and Cgd are thus reduced simultaneously, and a semiconductor device that is markedly improved in PAE and low in power consumption is realized. The structure of this embodiment is very effective for a high frequency such as millimeter waves because the characteristics of the gain and the drain efficiency are such that the gain and the drain efficiency decrease when the frequency rises. The second embodiment which uses a plurality of Al compositions and is accordingly capable of selective etching has an additional effect in that the controllability of a process is improved and that electric characteristics are stabilized.

Third Embodiment

In the second embodiment described above, Barrier Two (reference symbol: 15) has a low Al composition and Barrier Three (reference symbol: 16) has a high Al composition. A third embodiment describes an example in which Barrier Two has a high Al composition and Barrier Three has a low Al composition.

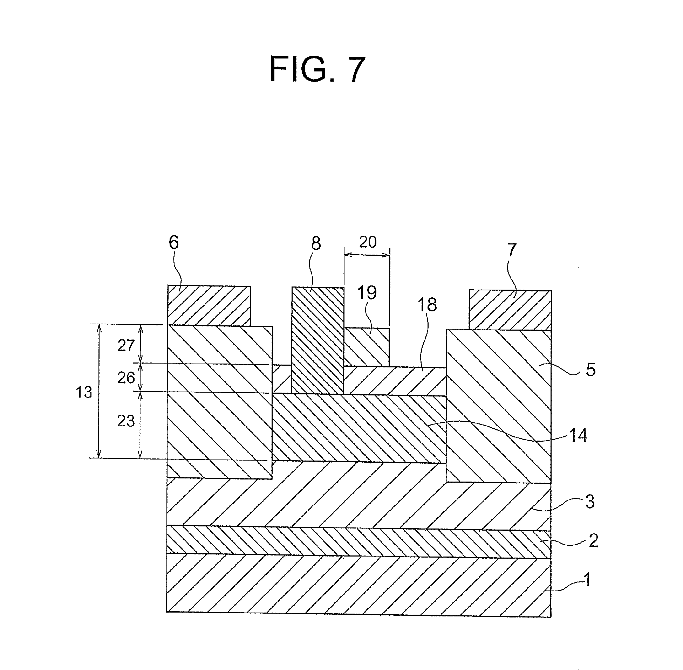

FIG. 7 is a sectional view illustrating the structure of a semiconductor device according to the third embodiment. In FIG. 7, reference symbol 18 denotes an AlGaN barrier that has an Al composition equal to or higher than that of Barrier One (reference symbol: 14) (hereinafter referred to as Barrier Two); 19, an AlGaN barrier that has a lower Al composition than that of Barrier Two (reference symbol: 18) (hereinafter referred to as Barrier Three); 20, Distance Five of Barrier Three (reference symbol: 19); 26, the thickness of Barrier Two (reference symbol: 18) ; and 27, the thickness of Barrier Three (reference symbol: 19). In this embodiment, Barrier Two (reference symbol: 18) is provided on Barrier One (reference symbol: 14) between the gate electrode 8 and the drain electrode 7, and Barrier Three (reference symbol: 19) is further provided on Barrier Two (reference symbol: 18) in a region on the side of the gate electrode 8. The other components are the same as in the first embodiment or the second embodiment, and are denoted by the same reference symbols in order to omit their descriptions. In the third embodiment, similar to in the first and second embodiments, the barrier structure between the source electrode 6 and the gate electrode 8 is the same as the barrier structure of a region on the side of the drain electrode 7. Distance Five (reference symbol: 20) is substantially the same as Distance One (reference symbol: 10) of FIG. 1. The sum of the thicknesses 23, 26, and 27 is substantially equal to the thickness 13.

In the third embodiment, Barrier Two (reference symbol: 18) which is an AlGaN barrier having a high Al composition is stacked on Barrier One (reference symbol: 14) and, accordingly, Barrier Three (reference symbol: 19) which has a low Al composition in order to reduce the magnitude of polarization is stacked on top of Barrier Two (reference symbol: 18) only on the side of the gate electrode 8 between the gate electrode 8 and the drain electrode 7. This way, the magnitude of barrier layer polarization on the side of the gate electrode 8 is made smaller than that on the side of the drain electrode 7 in the third embodiment, too. Consequently, the electron concentration is low on the side of the gate electrode 8, which reduces Cgd, and is high on the side of the drain electrode 7, which reduces Rd. Further, similar to the first and second embodiments, Rs is reduced in the third embodiment by making the barrier structure between the source electrode 6 and the gate electrode 8 the same as the barrier structure on the side of the drain electrode 7.

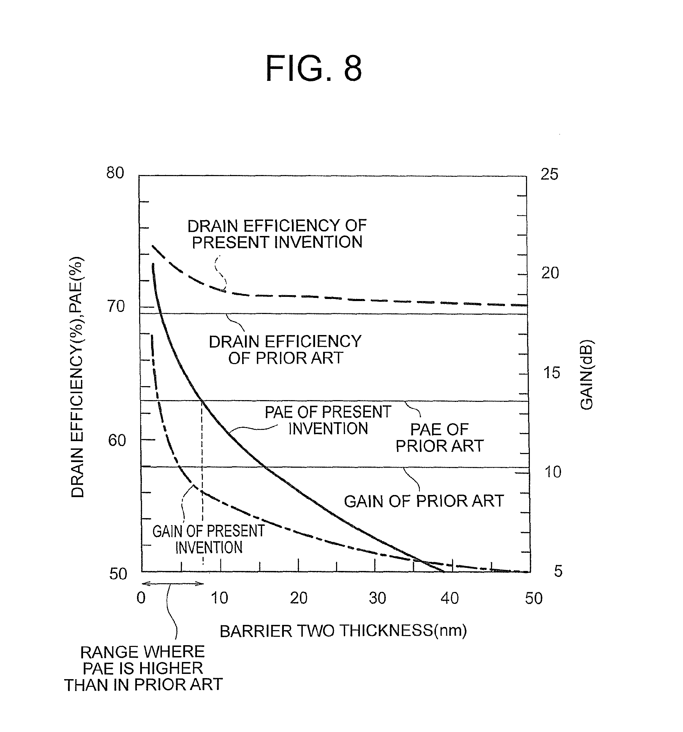

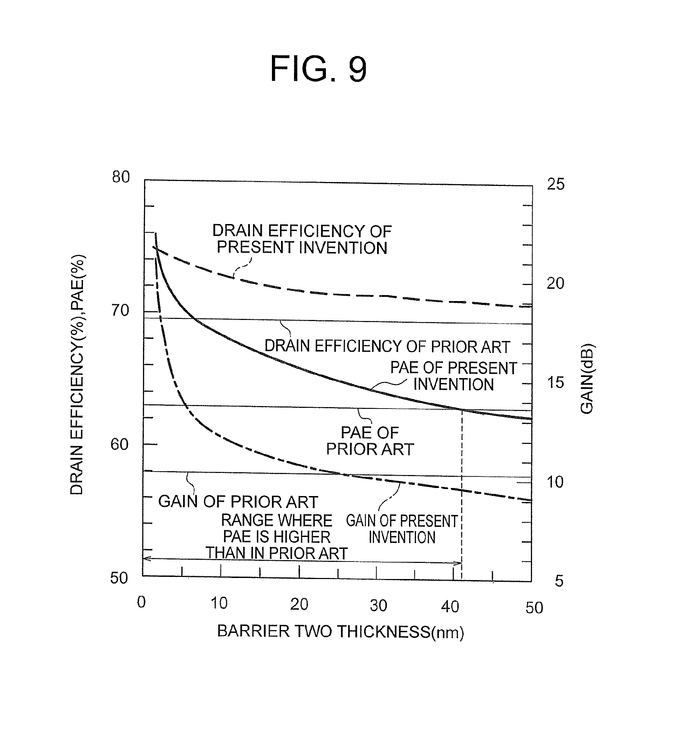

FIGS. 8 and 9 show results of calculating the gain, drain efficiency, and PAE of the structure of the third embodiment. FIGS. 8 and 9 show calculation results obtained for a structure in which Barrier One (reference symbol: 14) has the Al composition of 0.2 and the thickness 23 of 10 nm, similar to in the AlGaN barrier 9 of the first embodiment, when the thickness 26 of Barrier Two (reference symbol: 18) is varied. In FIG. 8, the Al composition of Barrier Two (reference symbol: 18) is 1 (AlN) and the thickness 27 of Barrier Three (reference symbol: 19) is 2 nm. In FIG. 9, the Al composition of Barrier Two (reference symbol: 18) is 0.3 and the thickness 27 of Barrier Three (reference symbol: 19) is 3 nm. The Al composition of Barrier Three is 0 (GaN) in FIGS. 8 and 9 both. It is understood from FIGS. 8 and 9 that the PAE improves when the thickness 26 of Barrier Two (reference symbol: 18) isthinner. A value higher than the PAE of prior art is obtained when the thickness 26 of Barrier Two (reference symbol: 18) is 8 nm or less in FIG. 8, and when the thickness 26 of Barrier Two (reference symbol: 18) is 42 nm or less in FIG. 9, thereby proving the effect of the third embodiment. From FIGS. 8 and 9, it is concluded that a desirable thickness 26 of Barrier Two (reference symbol: 18) is equal to or more than 10 nm and equal to or less than 40 nm.

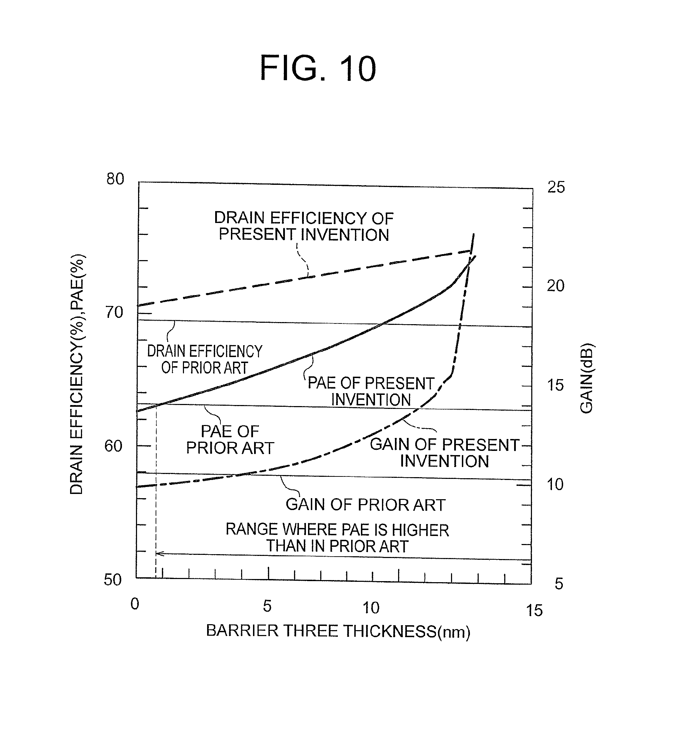

FIG. 10 shows a calculation result obtained when Barrier One (reference symbol: 14) has the same Al composition and thickness as in FIGS. 8 and 9, Barrier Two (reference symbol: 18) has an Al composition of 0.3 and a thickness of 30 nm as the thickness 26, and the thickness 27 of Barrier Three (reference symbol: 19) is varied. The Al composition of Barrier Three is 0 (GaN). It is understood from FIG. 10 that a PAE higher than in the prior art example is accomplished when the thickness 27 of Barrier Three (reference symbol: 19) is 1 nm or more.

In the calculations of FIGS. 8 to 10, Distance Three (reference symbol: 22) between the gate electrode 8 and the n+ region 5 is 3 $\mu$m, and Distance Five (reference symbol: 20) on the side of the gate electrode 8 is 1 $\mu$m.

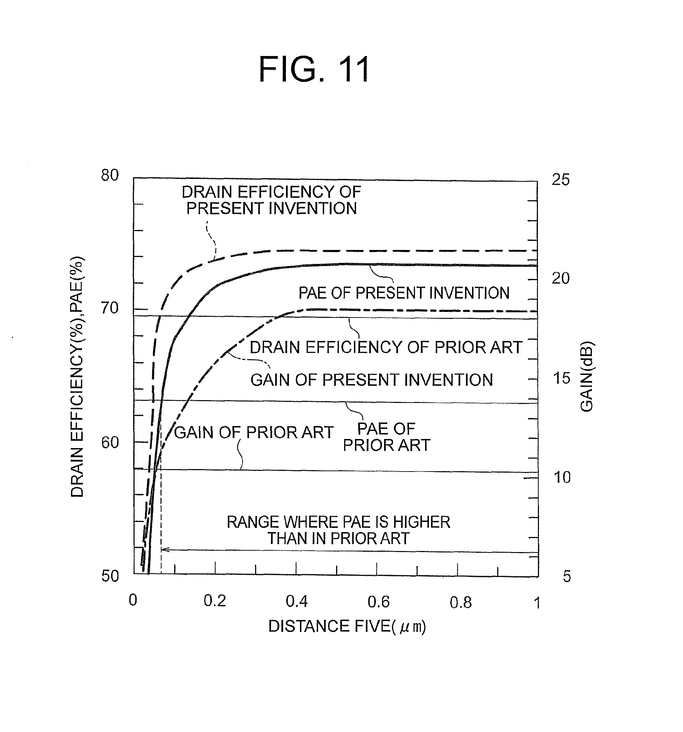

FIG. 11 shows a calculation result obtained when Barrier Two (reference symbol: 18) has an Al composition of 0.3 and a thickness of 2 nm as the thickness 26, Barrier Three (reference symbol: 19) has an Al composition of 0 and a fixed thickness of 3 nm as the thickness 27, and Distance Five (reference symbol: 20) on the side of the gate electrode 8 is varied. It is understood from FIG. 11 that a PAE higher than in the prior art example is obtained when Distance Five (reference symbol: 20) is 0.07 $\mu$m or more. The value of Distance Five (reference symbol: 20) (0.07 $\mu$m) is very small compared to Distance Three (reference symbol: 22) between the gate electrode 8 and the n+ region 5 which is 3 $\mu$m. Therefore, the portion formed along Distance Five (reference symbol: 20), which is formed so as to reduce Cgd, has hardly influence on Rd. The same can be said for the first and second embodiments described above.

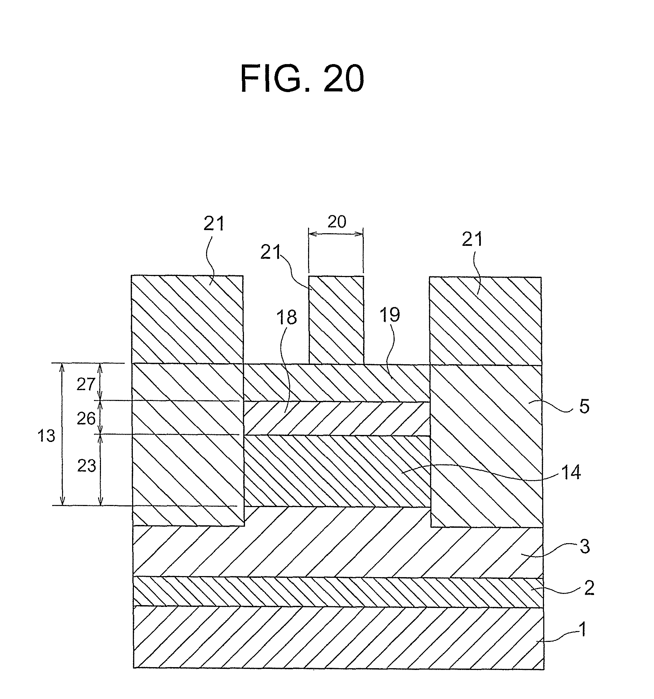

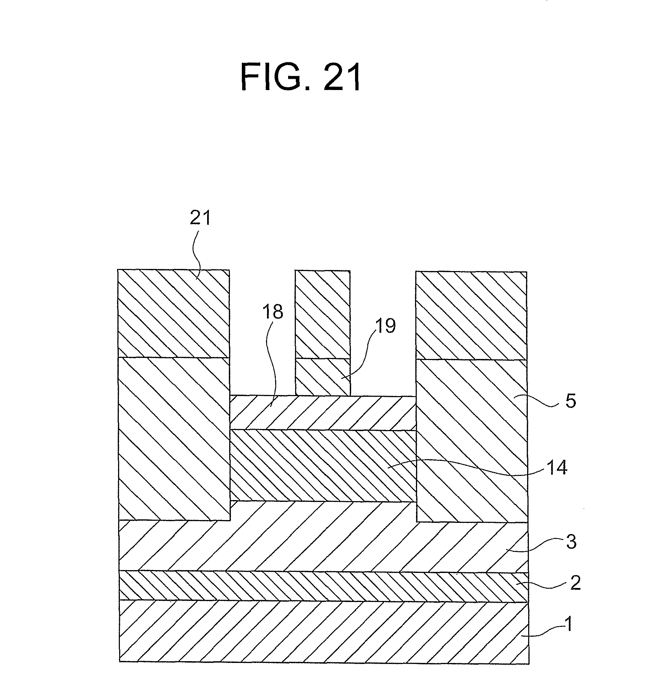

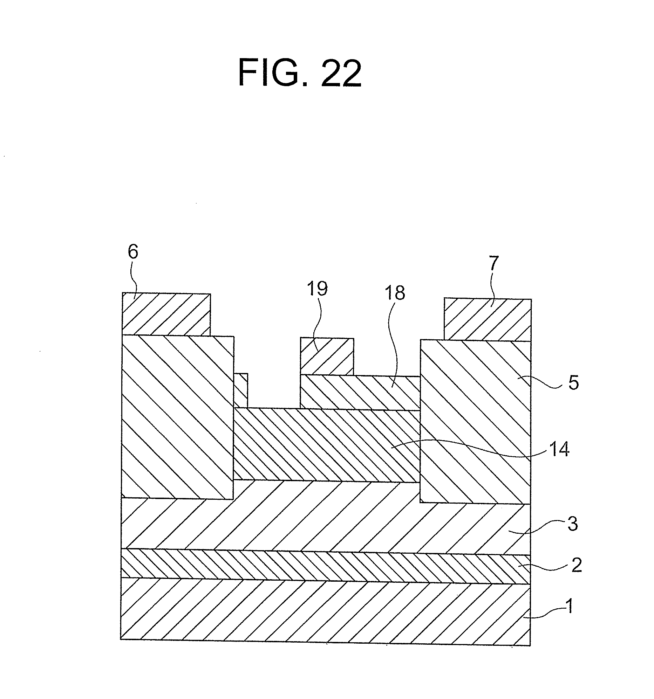

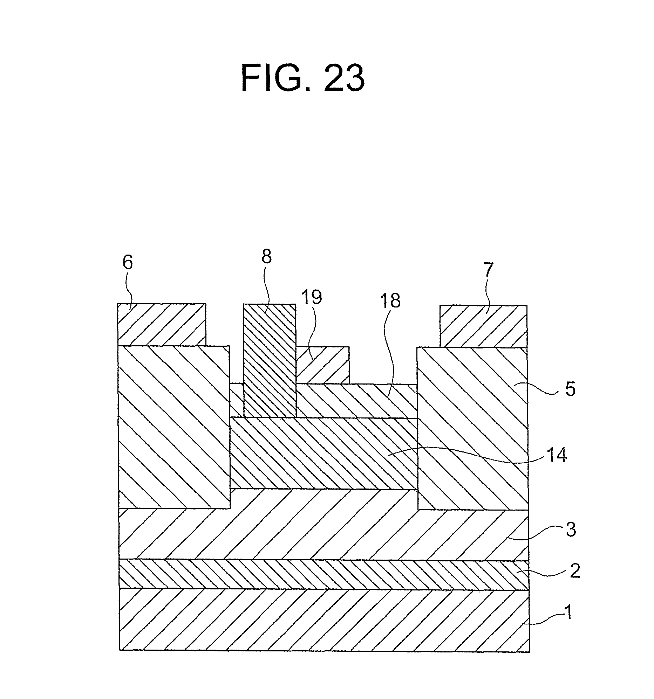

A manufacturing method of the third embodiment is described next with reference to FIGS. 20 to 23. This manufacturing method is carried out the same way as in the second embodiment (FIGS. 16 to 19). Specifically, the buffer 2, the GaN channel 3, Barrier One (reference symbol: 14), Barrier Two (reference symbol: 18), and Barrier Three (reference symbol: 19) are sequentially grown on the substrate 1 first through crystal growth by a crystal growth method such as MOCVD or MBE. Barrier Two (reference symbol: 18) and Barrier Three (reference symbol: 19) do not need to be crystal layers and may be polycrystalline or amorphous layers. Therefore, Barrier Two (reference symbol: 18) and Barrier Three (reference symbol: 19) may be formed by other methods such as sputtering or evaporation. Barrier One, Barrier Two, and Barrier Three are formed so that the sum of the thickness 23 of Barrier One (reference symbol: 14), the thickness 26 of Barrier Two (reference symbol: 18), and the thickness 27 of Barrier Three (reference symbol: 19) is equal to the thickness 13. Next, as illustrated in FIG. 20, the resist 21 is formed to have an opening in a portion where Barrier Three (reference symbol: 19) is to be removed. Selectively removing Barrier Three (reference symbol: 19) by plasma etching or chemical etching creates a structure illustrated in FIG. 21. In this etching, the resist 21 that is formed on Barrier Three (reference symbol: 19) is given a width equal to Distance Five (reference symbol: 20). Next, the resist 21 is removed to form the n+ region 5, the source electrode 6, and the drain electrode 7 by photolithography and lift-off. Another resist is formed to have an opening in a portion where Barrier Two (reference symbol: 18) is to be removed. Barrier Two (reference symbol: 18) is then selectively removed by plasma etching or chemical etching. After the etching, removing this resist reveals that Barrier Two (reference symbol: 18) has been removed selectively as illustrated in FIG. 22. Next, the gate electrode 8 is formed in the portion from which Barrier Two (reference symbol: 18) has been removed as illustrated in FIG. 23. In the etching of FIG. 22, AlGaN that contains GaN and that has a low Al composition (Barrier Two) can be removed selectively by adding gas that contains oxygen or fluorine to chlorine gas. In the etching of FIG. 20, AlN or AlGaN that has a high Al composition (Barrier Three) can be removed selectively by a liquid that contains KOH. The etching in this case is performed effectively by irradiating the barrier with light. The etching of a polycrystalline or amorphous barrier layer tends to be easier than the etching of a crystal barrier layer.

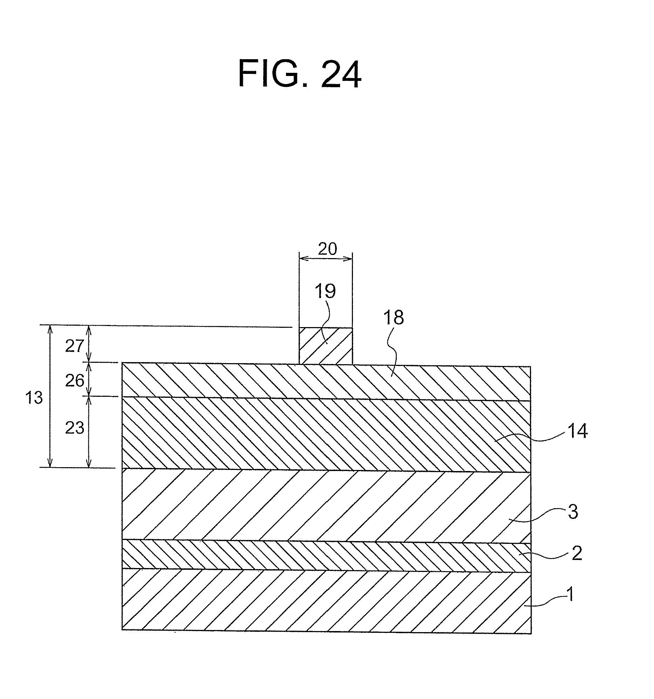

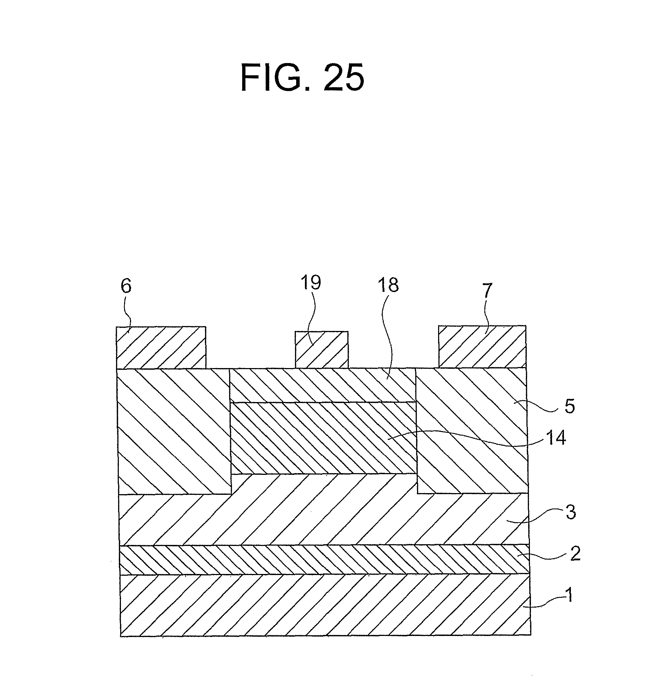

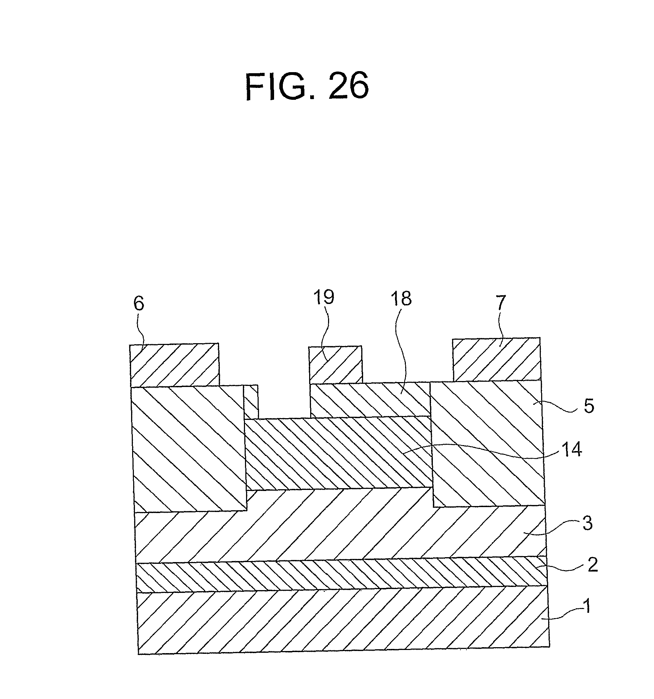

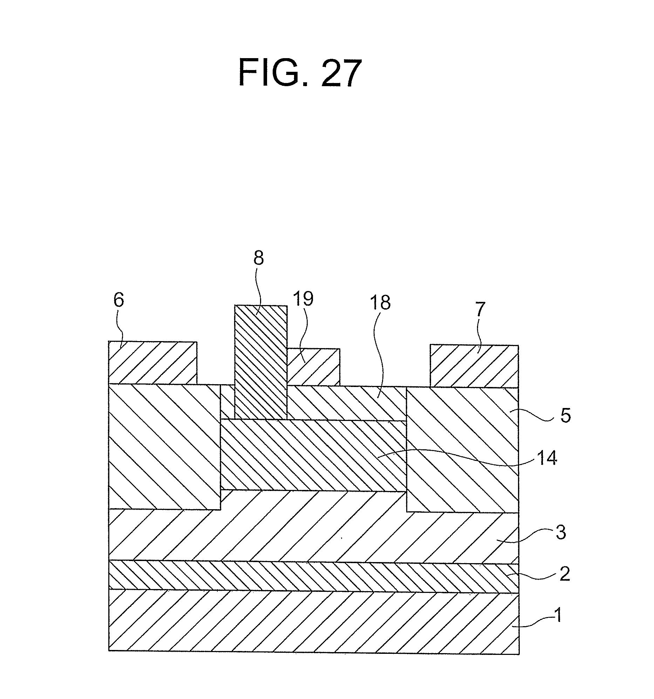

Alternatively, as illustrated in FIGS. 24 to 27, the source electrode 6 and the drain electrode 7 in the third embodiment may be formed (FIG. 25) by removing the barrier 19 entirely except for a necessary portion (FIG. 24). Specifically, as illustrated in FIG. 24, the buffer 2, the GaN channel 3, Barrier One (reference symbol: 14), Barrier Two (reference symbol: 18), and Barrier Three (reference symbol: 19) are sequentially grown on the substrate 1 through crystal growth by a crystal growth method such as MOCVD or MBE. Next, a resist is formed on Barrier Three (reference symbol: 19) to selectively remove Barrier Three (reference symbol: 19) by etching, leaving only a portion of Barrier Three (reference symbol: 19) as illustrated in FIG. 24. The resist is then removed. The width of the portion of the barrier 19 which has not been removed by the etching is equal to Distance Five (reference symbol: 20). Next, photolithography and lift-off are used to form the n+ region 5, the source electrode 6, and the drain electrode 7 as illustrated in FIG. 25. Another resist is formed on Barrier Two (reference symbol: 18) to selectively remove a portion of Barrier Two (reference symbol: 18) by etching as illustrated in FIG. 26. The resist is then removed. Next, the gate electrode 8 is formed in the portion from which Barrier Two (reference symbol: 18) has been removed as illustrated in FIG. 27. This way, the electron concentration can be increased below the source electrode 6 and the drain electrode 7 as well, which facilitates the obtainment of ohmic characteristics. FIGS. 25 to 27 show the n+ region 5, however, the GaN HEMT can operate normally without forming the n+ region 5.

As has been described, in the structure of the third embodiment, a plurality of barrier layers (Barrier One, Barrier Two, and Barrier Three) different from one another in Al composition are selectively stacked. Also, Barrier Three (reference symbol: 19) which has a low Al composition is provided on Barrier Two (reference symbol: 18) which has a high Al composition on the side of the gate electrode 8, and Barrier Two (reference symbol: 18) which has a high Al composition is only provided on the side of the drain electrode 7. This makes the magnitude of barrier layer polarization on the side of the gate electrode 8 smaller than on the side of the drain electrode 7. In the third embodiment, the thickness and composition of the barrier layer between the gate electrode 8 and the drain electrode 7 are thus controlled to set a low electron concentration on the side of the gate electrode 8 and to set a high electron concentration on the side of the drain electrode 7. The problem of the constraint of Cgd-Rd trade-off in prior art is thus solved and Cgd and Rd are reduced simultaneously. Further, Rs is reduced in the third embodiment by making the barrier structure between the source electrode 6 and the gate electrode 8 the same as the barrier structure on the side of the drain electrode 7. All of the three parameters Rd, Rs, and Cgd are thus reduced simultaneously, and a semiconductor device that is markedly improved in PAE and low in power consumption is realized. The structure of this embodiment is very effective for a high frequency such as millimeter waves because the characteristics of the gain and the drain efficiency are such that the gain and the drain efficiency decrease when the frequency rises.

The first to third embodiments described above deal with an example in which the gate electrode 8 has a rectangular shape. However, the shape of the gate electrode 8 is not limited thereto and may be a T shape for reducing the gate resistance. In this case, too, the effects of the present invention are obtained. A field plate for field relaxation or the like can also be applied as the gate electrode 8.

Reference Signs List

1 substrate, 2 buffer, 3 GaN channel, 5 n+ region, 6 source electrode, 7 drain electrode, 8 gate electrode, 9 AlGaN barrier, 10 distance one, 11 distance two, 12 thickness, 13 thickness, 14 barrier one, 15 barrier two, 16 barrier three, 17 distance, 18 barrier two, 19 barrier three, 20 distance five, 21 resist, 22 distance three, 23 thickness, 24 thickness, 25 thickness, 26 thickness, 27 thickness.

**Claims**

1. A semiconductor device, comprising:

a GaN channel layer which is provided on a substrate and through which electrons run;
a barrier layer which is provided on the GaN channel layer and which includes N and at least one of In, Al, and Ga;
a gate electrode which is provided on the barrier layer; and
a source electrode and a drain electrode which are provided on the substrate across the gate electrode,
wherein, in the barrier layer between the gate electrode and the drain electrode, a magnitude of polarization on the gate electrode side is smaller than that on the drain electrode side.

**2.** A semiconductor device according to claim 1,
wherein the barrier layer between the gate electrode and the drain electrode is composed of $Al_xGa_{1-x}N$ ($0<x\leq1$), and
wherein a thickness of a region of the barrier layer on the gate electrode side is thinner than that of a region of the barrier layer on the drain electrode side.

**3.** A semiconductor device according to claim 1,
wherein the barrier layer between the gate electrode and the drain electrode includes at least three layers of $Al_xGa_{1-x}N$ ($0<x\leq1$), $Al_yGa_{1-y}N$ ($0\leq y<1$), and $Al_zGa_{1-z}N$ ($0<z\leq1$), which have different Al compositions,
wherein x and y satisfy a relation x>y, and y and z satisfy a relation y<z,
wherein, the $Al_zGa_{1-z}N$ layer of the three layers is partially or entirely removed from a region of the barrier layer on the gate electrode side, and
wherein only the $Al_xGa_{1-x}N$ layer of the three layers is provided below the gate electrode.

**4.** A semiconductor device according to claim 1,
wherein the barrier layer between the gate electrode and the drain electrode includes at least three layers of $Al_xGa_{1-x}N$ ($0<x\leq1$), $Al_yGa_{1-y}N$ ($0\leq y\leq1$), and $Al_zGa_{1-z}N$ ($0\leq z<1$), which have different Al compositions,
wherein x and y satisfy a relation x<y, and y and z satisfy a relation y>z,
wherein the $Al_zGa_{1-z}N$ layer of the three layers is partially or entirely removed from a region of the barrier layer on the drain electrode side, and
wherein only the $Al_xGa_{1-x}N$ layer of the three layers is provided below the gate electrode.

**5.** A semiconductor device according to claim 4, wherein the $Al_zGa_{1-z}N$ layer ($0\leq z<1$), comprises a GaN layer (z=0).

**6.** A semiconductor device according to claim 3, wherein the region on the gate electrode side from which the $Al_zGa_{1-z}N$ has been removed partially or entirely has a length of 0.07 $\mu$m or more.

**7.** A semiconductor device according to claim 4 or 5, wherein, when the $Al_zGa_{1-z}N$ layer is removed partially or entirely from the region on the drain electrode side, a region on the gate electrode side where the $Al_zGa_{1-z}N$ layer is left has a length of 0.07 $\mu$m or more.

**8.** A semiconductor device according to any one of claims 3 to 7, wherein at least one of the $Al_yGa_{1-y}N$ layer and the $Al_zGa_{1-z}N$ layer is formed from a polycrystalline or amorphous film.

**9.** A semiconductor device according to any one of claims 1 to 8, wherein the barrier layer has a structure between the gate electrode and the source electrode that is the same as a structure in a region of the barrier layer on the drain electrode side.

**10.** A method of manufacturing a semiconductor device, the method comprising:

forming on a substrate a GaN channel layer through which electrons run;
forming on the GaN channel layer a barrier layer which includes N and at least one of In, Al, and Ga;
forming a gate electrode on the barrier layer; and
forming on the substrate a source electrode and a drain electrode on both sides of the gate electrode,
wherein, when forming the barrier layer between the gate electrode and the drain electrode, at least one of a thickness and a composition of the barrier layer is adjusted so that a magnitude of polarization on the gate electrode side is smaller than that on the drain electrode side.

# FIG. 1

# FIG. 2

# FIG. 3

# FIG. 4

# FIG. 5

DRAIN EFFICIENCY OF PRESENT INVENTION

PAE OF PRESENT INVENTION

DRAIN EFFICIENCY OF PRIOR ART

GAIN OF PRESENT INVENTION

PAE OF PRIOR ART

GAIN OF PRIOR ART

DRAIN EFFICIENCY(%),PAE(%)

GAIN(dB)

BARRIER TWO THICKNESS(nm)

# FIG. 6

# FIG. 7

# FIG. 8

# FIG. 9

# FIG. 10

# FIG. 11

# FIG. 12

# FIG. 13

# FIG. 14

# FIG. 15

# FIG. 16

# FIG. 17

# FIG. 18

# FIG. 19

EP 2 562 799 A1

# FIG. 20

31

EP 2 562 799 A1

# FIG. 21

32

# FIG. 22

# FIG. 23

# FIG. 24

# FIG. 25

# FIG. 26

# FIG. 27

## INTERNATIONAL SEARCH REPORT

| International application No. |
|---|
| PCT/JP2010/057141 |

**A. CLASSIFICATION OF SUBJECT MATTER**
*H01L21/338*(2006.01)i, *H01L29/778*(2006.01)i, *H01L29/812*(2006.01)i

According to International Patent Classification (IPC) or to both national classification and IPC

**B. FIELDS SEARCHED**

Minimum documentation searched (classification system followed by classification symbols)
H01L21/338, H01L29/778, H01L29/812

Documentation searched other than minimum documentation to the extent that such documents are included in the fields searched
Jitsuyo Shinan Koho          1922-1996          Jitsuyo Shinan Toroku Koho          1996-2010
Kokai Jitsuyo Shinan Koho          1971-2010          Toroku Jitsuyo Shinan Koho          1994-2010

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>A | JP 2002-016245 A (NEC Corp.),<br>18 January 2002 (18.01.2002),<br>fig. 8<br>& US 2002/0017648 A1 | 1,2,9,10<br>3-8 |
| X<br>A | JP 2006-286740 A (Eudyna Devices Inc.),<br>19 October 2006 (19.10.2006),<br>fig. 2 to 6<br>& US 2006/0220065 A1 | 1,2,10<br>3-9 |
| A | JP 2007-067240 A (Toshiba Corp.),<br>15 March 2007 (15.03.2007),<br>fig. 1 to 15<br>& US 2007/0045670 A1 | 1-10 |

☒ Further documents are listed in the continuation of Box C.          ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>09 July, 2010 (09.07.10) | Date of mailing of the international search report<br>20 July, 2010 (20.07.10) |
|---|---|
| Name and mailing address of the ISA/<br>Japanese Patent Office | Authorized officer |
| Facsimile No. | Telephone No. |

Form PCT/ISA/210 (second sheet) (July 2009)

<table>
<tr><td colspan="2">**INTERNATIONAL SEARCH REPORT**</td><td>International application No.<br>PCT/JP2010/057141</td></tr>
</table>

C (Continuation).　DOCUMENTS CONSIDERED TO BE RELEVANT

| Category* | Citation of document, with indication, where appropriate, of the relevant passages | Relevant to claim No. |
|---|---|---|
| A | JP 2005-079346 A　(Toshiba Corp.),<br>24 March 2005 (24.03.2005),<br>fig. 1 to 24<br>(Family: none) | 1-10 |
| A | JP 2001-230407 A　(Matsushita Electric Industrial Co., Ltd.),<br>24 August 2001 (24.08.2001),<br>fig. 1 to 8<br>& US 2001/0015446 A1 | 1-10 |
| A | JP 2010-003959 A　(Sanken Electric Co., Ltd.),<br>07 January 2010 (07.01.2010),<br>fig. 1 to 10<br>& US 2009/0315075 A1 | 1-10 |
| A | JP 2007-227884 A　(Matsushita Electric Industrial Co., Ltd.),<br>06 September 2007 (06.09.2007),<br>fig. 1 to 13<br>& US 2007/0176204 A1 | 1-10 |

Form PCT/ISA/210 (continuation of second sheet) (July 2009)

<table>
<tr><td><strong>INTERNATIONAL SEARCH REPORT</strong></td><td>International application No.<br>PCT/JP2010/057141</td></tr>
</table>

**Box No. II    Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III    Observations where unity of invention is lacking (Continuation of item 3 of first sheet)**

This International Searching Authority found multiple inventions in this international application, as follows:
The matter described in claim 1 is not novel as described in the document 1 (JP 2002-016245 A (NEC Corp.), 18 January 2002 (18.01.2002), fig. 8) and the document 2 (JP 2006-286740 A (Eudyna Devices Inc.), 19 October 2006 (19.10.2006), fig. 2 - 6)
Therefore, there is no common matter involving a special technical feature in the meaning of the second sentence of PCT Rule 13.2 among claims 1 - 10, and consequently, claims 1 - 10 do not satisfy the requirement of unity of invention.

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**    ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Current Status of X-Band and Ku-Band High Power GaN HEMTs. *IEICE Transactions,* 2009, vol. J92-C, 762

- **KAZUTAKA TAKAGI.** Current Status of X-Band and Ku-Band High Power GaN HEMTs. *IEICE Transactions, The Institute of Electronics,Information and Communication Engineers,* vol. J92-C (12), 762-769